# EUROPÄISCHE PATENTSCHRIFT

(11) **EP 4 232 514 B1**
(45) Veröffentlichungstag und Bekanntmachung des Hinweises auf die Patenterteilung: **10.09.2025**
(21) Anmeldenummer: 21798565.4
(22) Anmeldetag: 14.10.2021
(51) Int. Cl.: C09C 1/00, C08J 3/12

(54) **HERSTELLUNG VON PIGMENTEN MIT DEFINIERTER GROESSE UND FORM**
PRODUCTION OF PIGMENTS HAVING A DEFINED SIZE AND SHAPE
PRODUCTION DE PIGMENTS AYANT UNE TAILLE ET UNE FORME DÉFINIES

(30) Priorität: 20.10.2020 DE 102020006455
(43) Veröffentlichungstag der Anmeldung: 30.08.2023
(73) Patentinhaber: Giesecke+Devrient Currency Technology GmbH, 81677 München (DE)
(72) Erfinder: SCHERER, Maik Rudolf Johann, 82491 Grainau (DE); SCHERER, Kai Herrmann, 81539 München (DE)
(74) Vertreter: Patentanwälte Geyer, Fehners & Partner mbB
(86) Internationale Anmeldenummer: PCT/EP2021/025403
(87) Internationale Veröffentlichungsnummer: WO 2022/083889

(56) Entgegenhaltungen:
- EP-A2- 2 316 892
- WO-A2-2007/105001

## Beschreibung

Die Erfindung betrifft ein Verfahren zur Herstellung von Pigmenten definierter Größe und Form.

Herstellungsverfahren zur Erzeugung von Pigmenten oder Partikeln sind bekannt aus EP2039729 A2, EP2062947 A1 und EP2021401 A2. Dabei werden Sollbruchstellen einer Schicht, aus der die Pigmente oder Partikel erzeugt werden, durch Vorsehen sogenannter Wände in einer Matrize bereitgestellt, auf der die Schicht aufgebracht wird. Gemäß EP2316892 A2 können Sollbruchstellen einer Schicht, aus der die Pigmente oder Partikel erzeugt werden, durch einen Höhenversatz benachbarter planparalleler Strukturen in einer Matrize erzeugt werden. Auch die WO 2007/105001 A2 und die EP 2 316 892 A2 beschreiben Verfahren zur Pigmentherstellung.

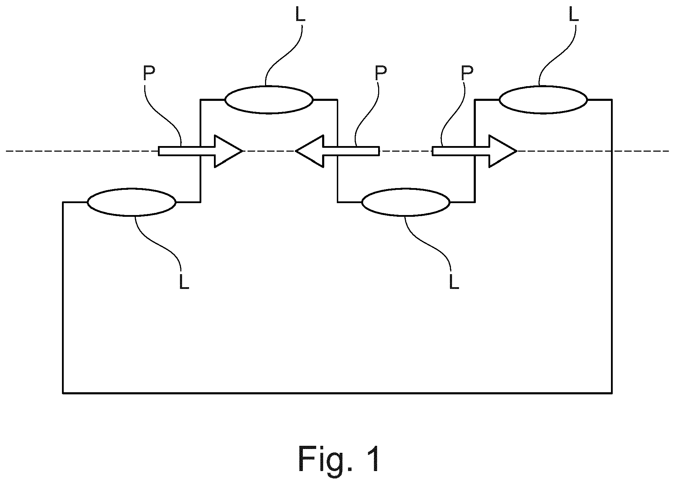

Verfahren zur Erzeugung von Matrizen für die Herstellung von Pigmenten können zu Oberflächenstörungen der Matrize und daher zu Oberflächendefekten der damit erzeugten Pigmente führen. Beispielweise entstehen bei Prägeverfahren zur Erzeugung von Matrizen typischerweise Luftblasen im Prägematerial. Dies hat bei Matrizen mit planparallelen höhenversetzten Prägestrukturen, die für die Herstellung von Pigmenten bestimmt sind, zur Folge, dass sich die Luftblasen in den Bereichen der Prägestruktur sammeln, mit denen die optisch aktiven Bereiche der Pigmente erzeugt werden. Dies führt zu Oberflächenstörungen der Pigmente und zur Beeinträchtigung der optischen Qualität der Pigmente. Ferner muss beim Prägen planparalleler Strukturen eine maximale Menge des Prägematerials verdrängt werden. Fig. 1 zeigt schematisch einen Querschnitt durch eine planparallele Prägestruktur. Luftblasen L sammeln sich beim Prägen an den planparallelen Ebenen, die Pfeile P veranschaulichen einen Materialfluss beim Prägen. Der Materialfluss beim Prägen planparalleler Strukturen erfolgt in gegenläufigen Richtungen. Durch die für planparallele Prägestrukturen erforderliche Verdrängung einer hohen Menge an Material kann die Qualität der Prägung beeinträchtigt werden. Beim Entformen kann es zudem zu Lackanhaftungen kommen.

Es soll daher ein Herstellungsverfahren für Pigmente hoher Qualität bereitgestellt werden.

Die Erfindung ist im unabhängigen Anspruch 1 definiert. Die abhängigen Ansprüche betreffen bevorzugte Weiterbildungen.

Die Erfindung betrifft ein Verfahren zur Herstellung von Pigmenten definierter Größe und Form, mit den Schritten: a) Erzeugen einer dreidimensionalen Oberflächenstruktur auf einem Substrat, wobei Oberflächenbereiche gebildet werden, die jeweils eine schräg zu einem Basisniveau der Oberflächenstruktur verlaufenden Steigung aufweisen, und in relativ zueinander versetzten Spalten angeordnet werden; b) Aufbringen einer Pigmentmaterialschicht auf der Oberflächenstruktur; c) Ablösen der Pigmentmaterialschicht von der Oberflächenstruktur und Erzeugen von Pigmenten.

Da mit dem Verfahren auf dem Substrat zumindest teilweise eine Vielzahl von Oberflächenbereichen gebildet wird, die jeweils zumindest teilweise eine schräg zu einem Basisniveau der Oberflächenstruktur verlaufende Steigung aufweisen, werden planparallele Oberflächen der Oberflächenstruktur vermieden. Beispielsweise besitzen zumindest ein Teil der Oberflächenbereiche jeweils eine schräg zu dem Basisniveau der Oberflächenstruktur verlaufende, insbesondere ebene, Fläche mit der Steigung. Eine ungünstige Ansammlung von Luftblasen oder anderer Oberflächenstörungen in der Oberflächenstruktur wird vermieden, insbesondere bei Einsatz eines Prägeverfahrens in Schritt a). Evtl. entstehende Luftblasen/Oberflächenstörungen sammeln sich am höchsten oder am tiefsten Punkt der Oberflächenbereiche. Daraus resultierende Oberflächendefekte der mit der Oberflächenstruktur erzeugten Pigmente entstehen an deren Rändern und beeinflussen deren optische oder funktionelle Eigenschaften nicht oder nur in geringem Ausmaß.

Wird die dreidimensionale Oberflächenstruktur im Schritt a) mit einem Prägeverfahren erzeugt, ist ferner die zu verdrängende Menge an Prägematerial gering. Beim Prägen muss das zu verdrängende Material nur innerhalb eines Oberflächenbereiches transportiert werden. Damit wird der Prägeprozess technisch signifikant erleichtert und die Qualität der Oberflächenstruktur und somit der im weiteren Verlauf des Verfahrens erzeugten Pigmente steigt.

Die Steigung der Oberflächenbereiche sowie die Anordnung der Oberflächenbereiche in relativ zueinander versetzten Spalten führen außerdem zu einem Höhenversatz. Auf diese Weise werden in der auf der Oberflächenstruktur aufgebrachten Pigmentmaterialschicht Sollbruchstellen für die Erzeugung der Pigmente bereitgestellt. Die Qualität der unter Verwendung der Oberflächenstruktur erzeugten Pigmente kann so erhöht werden.

Die Steigung mindestens eines Teils der Oberflächenbereiche kann ausgehend von dem Basisniveau der Oberflächenstruktur ausgebildet werden. So kann das Basisniveau der Oberflächenstruktur auch das Basisniveau der Oberflächenbereiche vorgeben. Ferner kann die Steigung mindestens eines Teils der Oberflächenbereiche jeweils einen gleichen Steigungsvektor definieren. Auf diese Weise kann die Steigung der betreffenden Oberflächenbereiche jeweils in gleicher Richtung verlaufen und die Oberflächenbereiche können die gleiche räumliche Orientierung besitzen. Zudem kann die Steigung mindestens eines Teils der Oberflächenbereiche bis zu einem Topniveau der Oberflächenstruktur verlaufend ausgebildet werden. So können ein Topniveau oder unterschiedliche Topniveaus der Oberflächenstruktur auch Topniveaus der Oberflächenbereiche vorgeben. Dabei kann das jeweilige Topniveau der Oberflächenbereiche benachbart zu dem Basisniveau eines angrenzenden Oberflächenbereiches derselben Spalte ausgebildet werden. Auf diese Weise können in den Spalten Erhebungen der Oberflächenbereiche in Höhe des Topniveaus mit Vertiefungen der Oberflächenbereiche in Höhe des Basisniveaus abwechselnd ausgebildet werden. Beispielsweise besitzt zumindest ein Teil der Oberflächenbereiche jeweils ausgehend von dem Basisniveau eine schräg zu dem Basisniveau bis zu einem Topniveau der Oberflächenstruktur mit der Steigung ansteigende, insbesondere im Wesentlichen ebene, Fläche, und die Fläche ist ausgehend vom Topniveau durch eine steil zum Basisniveau abfallende, z.B. zum Basisniveau senkrechte, insbesondere im Wesentlichen ebene, Fläche mit dem Basisniveau des in derselben Spalte angrenzenden Oberflächenbereichs verbunden. Die vorgenannten Maßnahmen unterstützen die Ausbildung von regelmäßigen, quasiperiodischen oder zufälligen Pigmentformen.

Die Steigungsvektoren mindestens eines Teils der Oberflächenbereiche können zueinander versetzt und/oder parallel zueinander angeordnet werden. Dadurch kann ein regelmäßiges Muster der Oberflächenbereiche und/oder ein erwünschter Höhenversatz zwischen den Oberflächenbereichen erzeugt werden.

Mindestens ein Teil der Spalten kann parallel zueinander angeordnet werden und/oder in einer Richtung angeordnet werden und/oder einen Spaltenvektor definieren. Auch durch diese Maßnahmen kann ein regelmäßiges Muster der Oberflächenbereiche erzeugt werden. Gleichzeitig wird die Anzahl der Oberflächenbereiche pro Flächeneinheit der Oberflächenstruktur optimiert.

Mindestens ein Teil der Oberflächenbereiche kann derart ausgebildet sein, dass die Projektion des jeweiligen Steigungsvektors auf das Basisniveau parallel zum Spaltenvektor verläuft. Dies verstärkt die Regelmäßigkeit der Anordnung der Oberflächenbereiche. Ferner wird die Anzahl der Oberflächenbereiche pro Flächeneinheit der Oberflächenstruktur optimiert.

Mit Maßnahmen zur Ausbildung einer regelmäßigen Anordnung und/oder eines regelmäßigen Musters der Oberflächenbereiche kann die Ausbeute an im Wesentlichen gleichförmigen Pigmenten erhöht werden. Zudem kann eine wohldefinierte, enge Größenverteilung der Pigmente erhalten werden, so dass auf ein Zermahlen der Pigmente nach dem Ablösen der Pigmentmaterialschicht von der Oberflächenstruktur verzichtet werden kann.

Mindestens ein Teil der Oberflächenbereiche kann jeweils mit einer absoluten Höhendifferenz von 0,1 µm bis 150 µm, bevorzugt 0,5 µm bis 20 µm, mehr bevorzugt 1 µm bis 10 µm ausgebildet werden. Diese Höhendifferenz erlaubt die Herstellung von gleichartigen Pigmenten vielfältiger Größenbereiche und begünstigt zudem die Erzeugung einer wohldefinierten, engen Größenverteilung der Pigmente.

Zumindest bei einem Teil der Oberflächenbereiche kann zwischen benachbarten Oberflächenbereichen der gleichen Spalte die gemittelte Höhendifferenz doppelt so groß ausgebildet sein wie die gemittelte Höhendifferenz zwischen Oberflächenbereichen benachbarter Spalten. Auf diese Weise wird ein Höhenversatz bereitgestellt, der die Zerkleinerung der Pigmentmaterialschicht in Einzelpigmente fördert.

Mindestens ein Teil der Oberflächenbereiche können mit gleicher Größe und/oder gleicher Form ausgebildet werden. Dies fördert die Erzeugung einer wohldefinierten, engen Größenverteilung der Pigmente. Die Bereitstellung von Oberflächenbereichen gleicher Form führt zu einer hohen Ausbeute an im Wesentlichen gleichförmigen Pigmenten.

Mindestens ein Teil der Oberflächenbereiche kann in Draufsicht auf die Oberflächenstruktur mit einer Kontur ausgewählt aus einer Polygonkontur, einer zueinander komplementären Kontur und einer Freiformkontur ausgebildet werden. Beispielsweise besitzen die Oberflächenbereiche jeweils eine schräg zu dem Basisniveau der Oberflächenstruktur verlaufende Fläche mit einer Polygonkontur oder einer Kontur eines Escher-Motivs. Dies fördert die Formenvielfalt der herstellbaren Pigmente.

Ferner kann mindestens ein Teil der Oberflächenbereiche mit einer oder mehreren Markierungen versehen werden, z.B. durch Prägen. Diese führen aufgrund ihrer Profilhöhe und/oder Ausformung nicht zu Sollbruchstellen in der Pigmentmaterialschicht. Beispielsweise können Markierungen der Oberflächenbereiche in Form von Escher-Motiven als Basis für eine entsprechende Markierung der Pigmente eingesetzt werden, z.B. auf Flächen der Oberflächenbereiche. Die Oberflächenbereiche können ferner mit Markierungen zur Erzeugung beispielsweise von Hologrammen, Nanostrukturen und/oder Mikrospiegeln für optische Effekte versehen werden.

Mindestens ein Teil der Oberflächenbereiche jeder Spalte kann im Querschnitt der Oberflächenstruktur in Richtung des Spaltenvektors als ein Sägezahnmuster ausgebildet werden. Dies fördert die Ausbildung eines Höhenversatzes zwischen Oberflächenbereichen innerhalb jeder Spalte, mit dem in der auf der Oberflächenstruktur erzeugten Pigmentmaterialschicht Sollbruchstellen für die Pigmente bereitgestellt werden.

Mindestens ein Teil der Spalten kann um die Hälfte einer Seitenlänge eines Oberflächenbereichs zueinander versetzt angeordnet werden. Dadurch kann zwischen benachbarten Spalten ein optimaler Höhenversatz zwischen den Oberflächenbereichen erzeugt werden.

In dem Verfahren von Ausführungsformen kann im Schritt a) das Erzeugen der dreidimensionalen Oberflächenstruktur auf dem Substrat zumindest teilweise durch ein Prägeverfahren erfolgen. Beispielsweise kann auf das Substrat eine Prägeschicht aufgebracht werden, die geprägt wird. Alternativ kann die Oberfläche des Substrats geprägt werden oder das Substrat kann mit der dreidimensionalen Oberflächenstruktur gegossen werden. Das Prägeverfahren kann z.B. in einem Rolle-zu Rolle-Prozess erfolgen. Das Substrat kann beispielsweise eine Trägerfolie sein, z.B. aus PET (Polyethylenterephthalat), PE (Polyethylen), PC (Polycarbonat), PVC (Polyvinylchlorid), PMMA (Polymethylmethacrylat) oder einer Kombination davon. Das Substrat kann alternativ aus einem starren Material gebildet sein, wie z.B. Quarz oder Glas.

Im Schritt a) des Verfahrens kann das Erzeugen der dreidimensionalen Oberflächenstruktur durch ein Verfahren erfolgen, ausgewählt aus: a1) Einem Prägeverfahren mit den Schritten: Aufbringen einer löslichen, insbesondere wasserlöslichen, Prägeschicht als Release-Schicht auf das Substrat und Durchführen eines lithografischen, insbesondere photolithografischen, Prozesses, eines Heißprägens oder eines UV-Prägens; und/oder a2) einem Prägeverfahren mit den Schritten: Bereitstellen eines mittels Heißprägen verformbaren Substrats oder Aufbringen einer unlöslichen Prägeschicht auf das Substrat, Durchführen eines Heißprägens oder eines UV-Prägens; und Aufbringen einer löslichen, insbesondere wasserlöslichen, Release-Schicht. Mit den vorgenannten Verfahren können die Vorteile des Verfahrens von Ausführungsformen besonders umfangreich realisiert werden. Es können in den Schritten a1) und/oder a2) ferner Markierungen geprägt werden, beispielsweise zur Erzeugung flacher Hologramme, Nanostrukturen und/oder von Mikrospiegeln auf den Pigmenten für optische Effekte.

Im Schritt a1) können lithographische Prozesse mittels Belichten und Entwickeln eingesetzt werden, bei denen ein als Release-Schicht aufgebrachter Release-Lack gleichzeitig als ein photolithographischer Resist genutzt wird. Ferner kann das UV-Prägen durch Bestrahlen der Release-Schicht mit UV-Licht durchgeführt werden, wobei die Release-Schicht einen löslichen, im UV-Frequenzbereich aushärtbaren Prägelack enthält oder daraus gebildet ist.

Im Schritt a2) kann die Release-Schicht mit einer Schichtdicke von 50 bis 7000 nm, bevorzugt von 100 bis 3000 nm aufgebracht werden. Ferner kann die Release-Schicht als eine mit der dreidimensionalen Oberflächenstruktur im Wesentlichen konforme Schicht aufgebracht werden, insbesondere mit einer im Wesentlichen konstanten Schichtdicke. Die Prägeschicht kann einen unlöslichen Heißpräge- oder UV-Lack enthalten oder daraus gebildet sein. Bei Anwendung des Schritts a2) kann das mit der Prägeschicht versehene Substrat wiederverwendet werden.

Im Schritt b) des Verfahrens von Ausführungsformen kann eine Pigmentmaterialschicht enthaltend ein oder mehrere anorganische Materialien und/oder ein oder mehrere organische Materialien auf der Oberflächenstruktur aufgebracht werden. Beispielsweise kann im Schritt b) eine Pigmentmaterialschicht durch Aufdampfen (Physical Vapour Deposition PVD, Chemical Vapour Deposition CVD) oder andere Beschichtungsverfahren aufgebracht werden. Das Aufbringen der Pigmentmaterialschicht kann ferner in einem Rolle-zu Rolle-Prozess erfolgen. Die Pigmentmaterialschicht kann als Monolage oder als Multilage aus gleichen oder unterschiedlichen Materialien ausgebildet werden. Die Pigmentmaterialschicht kann eine Metallisierung sein oder eine Metallisierung enthalten. Als Materialien für die Pigmentmaterialschicht können beispielsweise eingesetzt werden, einzeln oder in beliebiger Kombination in einer oder mehreren Schichten: ein Farbkippeffekt-Material (Colorshift (CS) Material, Dünnschichtinterferenzbeschichtung), ein Phasenwechsel-Material (Phase Change Material); ein magnetisches Material; ein oder mehrere gleiche oder unterschiedliche Materialien ausgewählt aus einem Metall, einer Legierung, einem Dielektrikum, einem Oxid, einem Sulfid, und einem Fluorid. Beispielsweise kann ein Farbkippeffekt-Material in Form eines oder mit einem Phasenwechsel-Material verwendet werden oder es kann ein magnetisches Farbkippeffekt-Material verwendet werden. Des Weiteren kann die Pigmentmaterialschicht auch eine oder mehrere organische Schichten umfassen, die beispielsweise mittels PVD, CVD, Drucken oder Sprühen aufgebracht werden.

Im Schritt c) des Verfahrens kann das Ablösen erfolgen durch: mechanisches Ablösen, z.B. mittels einem Schaber, Einsetzen eines Präge- oder Metalltransfers, Einsetzen einer Release-Schicht und/oder einer Templatschicht und Auflösen derselben. Das Ablösen kann z.B. in einem Rolle-zu Rolle-Prozess erfolgen. Beim Ablösen kann die Pigmentmaterialschicht in Bruchstücke zerkleinert werden. Dadurch können die Pigmente in der gewünschten Größe und Form unmittelbar erzeugt werden und es kann ein kostenintensives Mahlen der Pigmente vermieden werden. Alternativ oder zusätzlich können die abgelöste Pigmentmaterialschicht oder deren Bruchstücke und/oder die Pigmente gemahlen werden. Die Mahlparameter werden so gewählt, dass die Pigmentmaterialschicht entlang der vorgesehen Sollbruchstellen zerbricht. Es kann eine Oberflächenbehandlung der Pigmente und/oder ein Trocknen der Pigmente durchgeführt werden. Beispielsweise kann die Pigmentmaterialschicht durch Auflösen einer im Verlauf des Verfahrens unterhalb der Pigmentmaterialschicht aufgebrachten Release-Schicht von der Oberflächenstruktur mit einem Lösungsmittel, insbesondere Wasser, abgelöst werden. Dabei kann es sich insbesondere um die durch die vorgenannten Schritte a1) und a2) erzeugten Release-Schichten handeln.

Nachfolgend wird die Erfindung anhand von Ausführungsbeispielen unter Bezugnahme auf die beigefügten Zeichnungen, die ebenfalls erfindungswesentliche Merkmale offenbaren, noch näher erläutert. Diese Ausführungsbeispiele dienen lediglich der Veranschaulichung und sind nicht als einschränkend auszulegen. Beispielsweise ist eine Beschreibung eines Ausführungsbeispiels mit einer Vielzahl von Elementen oder Komponenten nicht dahingehend auszulegen, dass alle diese Elemente oder Komponenten zur Implementierung notwendig sind. Vielmehr können andere Ausführungsbeispiele auch alternative Elemente und Komponenten, weniger Elemente oder Komponenten oder zusätzliche Elemente oder Komponenten enthalten. Elemente oder Komponenten verschiedener Ausführungsbespiele können miteinander kombiniert werden, sofern nichts anderes angegeben ist. Modifikationen und Abwandlungen, welche für eines der Ausführungsbeispiele beschrieben werden, können auch auf andere Ausführungsbeispiele anwendbar sein. Zur Vermeidung von Wiederholungen werden gleiche oder einander entsprechende Elemente in verschiedenen Figuren mit gleichen Bezugszeichen bezeichnet und nicht mehrmals erläutert. In den Figuren zeigen:
- Fig. 1: schematisch einen Querschnitt durch eine planparallele Prägestruktur des Stands der Technik;
- Fig. 2a: schematisch eine Oberflächenstruktur eines ersten Ausführungsbeispiels in Draufsicht;
- Fig. 2b: schematisch die Oberflächenstruktur der Fig. 2a sowie eine Querschnittsansicht durch die Oberflächenstruktur der Fig. 2a;
- Fig. 2c: eine schematische Querschnittsansicht von Schichtfolgen im Schritt b) des ersten Ausführungsbeispiels;
- Fig. 3: schematisch eine Oberflächenstruktur eines zweiten Ausführungsbeispiels in Draufsicht sowie eine Querschnittsansicht durch die Oberflächenstruktur;
- Fig. 4: schematisch eine Querschnittsansicht durch eine Oberflächenstruktur gemäß des ersten und des zweiten Ausführungsbeispiels; und
- Fig. 5: schematisch ein Ablaufdiagramm des Verfahrens von Ausführungsformen.

Im Folgenden gilt für die Beschreibung von Wertebereichen, dass die Angabe eines breiten Bereichs mit engeren alternativen oder bevorzugten Bereichen auch Bereiche offenbart, die durch eine beliebige Kombination angegebener unterer Bereichsgrenzen mit angegebenen oberen Bereichsgrenzen gebildet werden können. Der Begriff "schräg zu einem Basisniveau der Oberflächenstruktur verlaufende Steigung" und Abwandlungen davon können vorliegend bedeuten, dass die Steigung relativ zu einer Ebene des Basisniveaus 0,01 bis 1, bevorzugt von 0,02 bis 0,75, besonders bevorzugt von 0,05 bis 0,5 beträgt. Beispielsweise für die Erzeugung von plättchenförmigen Pigmenten mit einer Dicke von 1µm und einer lateralen Abmessung von 30µm wird eine Steigung von 0,1 gewählt. Der Begriff "steil zum Basisniveau abfallende Fläche" und Abwandlungen davon können vorliegend bedeuten, dass die Fläche zum Basisniveau ungefähr senkrecht verläuft, z.B. in einem Bereich mit einer Abweichung von der Senkrechten von +/- 10°, bevorzugt +/-5°, mehr bevorzugt +/- 2°.

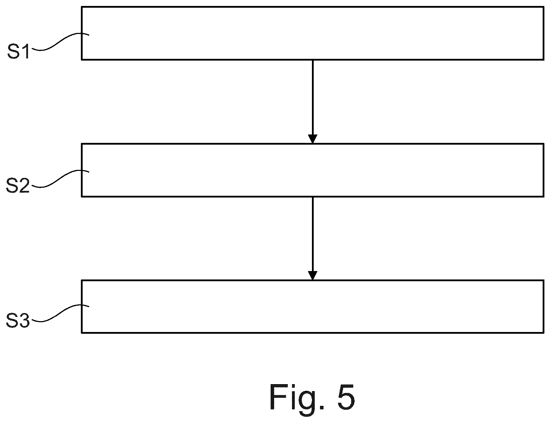

In einem ersten Ausführungsbeispiel wird im Schritt a) des Verfahrens eine dreidimensionale Oberflächenstruktur durch ein Prägeverfahren erzeugt, was im Ablaufdiagramm der Fig. 5 dem Schritt S1 entspricht. Hierfür wird eine Trägerfolie aus PET (Polyethylenterephthalat) als das Substrat bereitgestellt. Auf die Oberfläche der Trägerfolie wird eine Prägeschicht 13 aus einem löslichen Prägelack aufgebracht, die auch als Release-Schicht fungiert. Es wird eine wasserlösliche Prägeschicht aus beispielsweise Polyinylpyrrolidon (PVP), modifizierte Stärke, Polyacrylsäure, Polyethylenglycol, Hydroxypropylcellulose, Hydroxyethylcellulose, Casein, Gummi arabicum, Carboxymethylcellulose, Polyvinylalkohol (PVOH), Dextrin, oder einem Gemisch zweier oder mehrerer der vorstehend genannten Stoffe als ein thermoplastischer Heißprägelack mit einem Rolle-zu-Rolle-Prozess auf der Trägerfolie hergestellt. Im vorliegenden Beispiel wird PVOH verwendet. Die wasserlösliche Prägeschicht kann mit einer Schichtdicke von 500nm bis 20µm aufgedruckt werden. Die Release-Schicht kann beispielsweise mittels Tiefdruck, Flexodruck, Schlitzdüse oder Sprühdüse aufgetragen werden. Alternative thermoplastische Heißprägelacke können ausgewählt sein aus beispielsweise PMMA, PVA, PS, die in anderen Lösungsmitteln als Wasser löslich sind. Danach wird in einem Rolle-zu Rolle-Prozess durch Heißprägen des Prägelacks eine Oberflächenstruktur 10 mit im Wesentlichen gleichförmigen Oberflächenbereichen 12 erzeugt, die in Draufsicht ein Muster mit quadratischen Einheiten bilden. Der Prägelack kann dabei nur teilweise geprägt werden. Alternativ kann auch eine thermoplastisch verformbare Trägerfolie heißgeprägt werden.

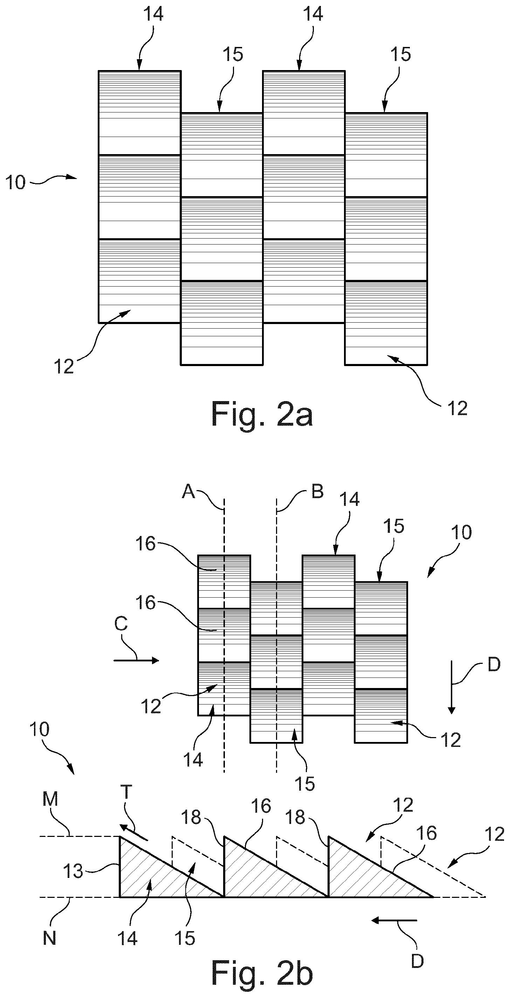

Fig. 2a stellt die erzeugte Oberflächenstruktur 10 schematisch in Draufsicht dar. Die Oberflächenbereiche 12 sind in relativ zueinander versetzten Spalten 14 und 15 angeordnet. Im vorliegenden Beispiel sind die Spalten 14 und 15 um die Hälfte einer Seitenlänge eines Oberflächenbereichs 12 zueinander versetzt angeordnet. Die Spalten 14 und 15 definieren in einer Richtung, die mit dem Pfeil D veranschaulicht ist, einen Spaltenvektor.

Fig. 2b zeigt schematisch die Oberflächenstruktur 10 der Fig. 2a sowie eine Querschnittsansicht entlang einer Ebene A durch eine der Spalten 14 der Oberflächenstruktur 10. Die Oberflächenbereiche 12 sind in der Prägeschicht 13 vorgesehen. Der Pfeil C repräsentiert die Blickrichtung auf den Querschnitt entlang der Ebene A, der in der Querschnittsansicht mit der durchgezogenen Linie dargestellt ist. Ein Querschnitt entlang der Ebene B repräsentiert den Umriss der Spalte 15, der in der Querschnittsansicht mit der gestrichelten Linie dargestellt ist und der in Blickrichtung C auf den Querschnitt der Ebene A hinter der Spalte 14 erkennbar ist. Die Spalten 14 und 15 zeigen im vorliegenden Ausführungsbeispiel jeweils im Querschnitt ein Sägezahnmuster.

Wie aus Fig. 2b ersichtlich ist, besitzen die in der Prägeschicht 13 gebildeten Oberflächenbereiche 12 jeweils eine quadratische ebene Fläche 16, die eine schräg zu einem Basisniveau N der Oberflächenstruktur 10 verlaufende Steigung m=0,5 hat. Die Steigung jeder Fläche 16 verläuft ausgehend vom Basisniveau N in eine Richtung, die mit dem Pfeil T dargestellt ist, und definiert in Richtung T für jeden Oberflächenbereich 12 einen gleichen Steigungsvektor. Die Projektion des Steigungsvektors auf das Basisniveau N verläuft im vorliegenden Ausführungsbeispiel parallel zum Spaltenvektor D.

Fig. 2b zeigt ferner, dass in diesem Beispiel die Fläche 16 der Oberflächenbereiche 12 mit der Steigung m ausgehend vom Basisniveau N bis zu einem Topniveau M der Oberflächenstruktur 10 verläuft. Im vorliegenden Beispiel ist das Topniveau M in jedem Oberflächenbereich 12 mit dem Basisniveau N des in der gleichen Spalte folgenden Oberflächenbereichs 12 durch eine zum Basisniveau N im Wesentlichen senkrechte ebene Fläche 18 verbunden. Auf diese Weise sind in den Spalten 14 und 15 Erhebungen der Oberflächenbereiche 12 in Höhe des Topniveaus M mit Vertiefungen der Oberflächenbereiche 12 in Höhe des Basisniveaus N abwechselnd ausgebildet. Die Höhendifferenz zwischen in einer Spalte 14, 15 aufeinanderfolgenden Oberflächenbereichen 12 beträgt im vorliegenden Beispiel 5 µm, während zwischen Oberflächenbereichen 12 benachbarter Spalten 14, 15 die Höhendifferenz 2,5 µm beträgt.

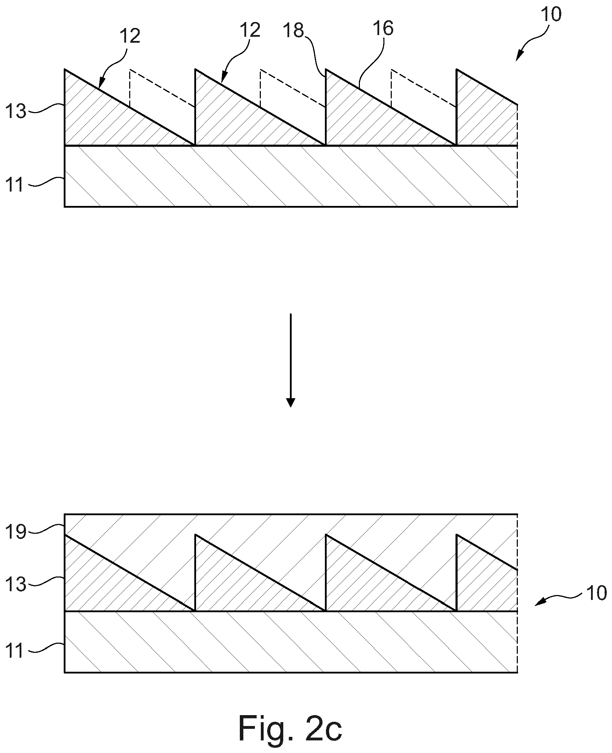

Wie in Fig. 2c mit einer schematischen Querschnittsansicht von Schichtfolgen gezeigt ist, wird im Schritt b) des Verfahrens eine Pigmentmaterialschicht 19 bestehend aus Kupfer auf der Oberflächenstruktur 10, d.h. auf der Prägeschicht 13 mit den Oberflächenbereichen 12, mit einem Rolle-zu-Rolle-Prozess aufgebracht. In alternativen Beispielen kann eine Pigmentmaterialschicht 19 bestehend aus einer mehrschichtigen Interferenzbeschichtung, gegebenenfalls doppelten Interferenzbeschichtung, aufgebracht werden. Dies entspricht im Ablaufdiagramm der Fig. 5 dem Schritt S2. Die Steigung der Oberflächenbereiche 12 führt zu einem Höhenversatz zwischen den Oberflächenbereichen 12 einer Spalte. Die Anordnung der Oberflächenbereiche 12 in relativ zueinander versetzten Spalten 14 und 15 führt zu einem Höhenversatz der Oberflächenbereiche 12 zwischen benachbarten Spalten. Auf diese Weise werden in der auf der Oberflächenstruktur aufgebrachten Pigmentmaterialschicht 19 Sollbruchstellen für die Erzeugung der Pigmente bereitgestellt.

In einigen Ausführungsbeispielen ist die Steigung m der einzelnen Oberflächenbereiche 12 so gewählt, dass der Höhenversatz größer ist als die Dicke der zu erzeugenden Pigmente. So können Pigmente aus Kupfer oder Aluminium nur 50nm dick sein, während ein Colorshiftpigment z.B. 1µm dick sein kann. Beispielsweise für die Erzeugung von plättchenförmigen Colorshiftpigmenten, die laterale Abmessungen von circa 30µm aufweisen sollen, wird die Steigung so gewählt, dass sich die auf der Oberflächenstruktur 10 in der Pigmentmaterialschicht gebildeten Pigmentplättchen bevorzugt um mindestens 1µm überragen, um zu vermeiden, dass die später von der Oberflächenstruktur abgelösten Pigmentplättchen zusammenhängen. Jedoch gibt es auch Ausführungsbeispiele, bei denen die Oberflächenstruktur 10 der Pigmentmaterialschicht gebildeten Pigmentplättchen entspricht oder diese sogar etwas unterschreitet.

Im Schritt c) des Verfahrens wird die Pigmentmaterialschicht 19 bestehend aus Kupfer von der Oberflächenstruktur 10 abgelöst, indem der Prägelack aus PVOH der Release-Schicht mit Wasser aufgelöst wird. Besteht der Prägelack der Release-Schicht aus einem wasserunlöslichen Thermoplasten, werden andere Lösungsmittel eingesetzt. Beim Ablösen wird durch Aufbrechen an den Sollbruchstellen der Pigmentmaterialschicht eine Vielzahl von Kupfer-Pigmenten mit im Wesentlichen gleicher quadratischer Form und mit einer engen Größenverteilung erzeugt. Dies entspricht im Ablaufdiagramm der Fig. 5 dem Schritt S3. Bei Verwendung einer mehrschichtigen Interferenzbeschichtung als Pigmentmaterialschicht 19 werden Interferenz-Pigmente erzeugt.

In einem zweiten Ausführungsbeispiel wird im Schritt a) des Verfahrens eine dreidimensionale Oberflächenstruktur ebenfalls durch ein Prägeverfahren erzeugt, was im Ablaufdiagramm der Fig. 5 dem Schritt S1 entspricht. Hierfür wird eine Trägerfolie aus PET (Polyethylenterephthalat) als das Substrat bereitgestellt. Auf die Oberfläche der Trägerfolie wird eine unlösliche Prägeschicht 130 aus wasser-unlöslichem Heißprägelack PMMA (Polymethylmethacrylat) in einem Rolle-zu-Rolle-Prozess aufgebracht. Alternative wasserunlösliche thermoplastische Heißprägelacke sind PVA (Polyvinylacetat) oder PS (Polystyrol). In der Prägeschicht 130 wird analog wie im ersten Beispiel mit einem Rolle-zu Rolle-Prozess durch Heißprägen eine Oberflächenstruktur 100 mit gleichförmigen Oberflächenbereichen 120 erzeugt, die jeweils eine hexagonale ebene Fläche 160 mit der Steigung m=0,5 aufweisen und in zueinander versetzten Spalten 140 und 150 angeordnet sind. Der Versatz zwischen den Spalten 140, 150 ergibt sich durch die hexagonale Kontur der Flächen 160.

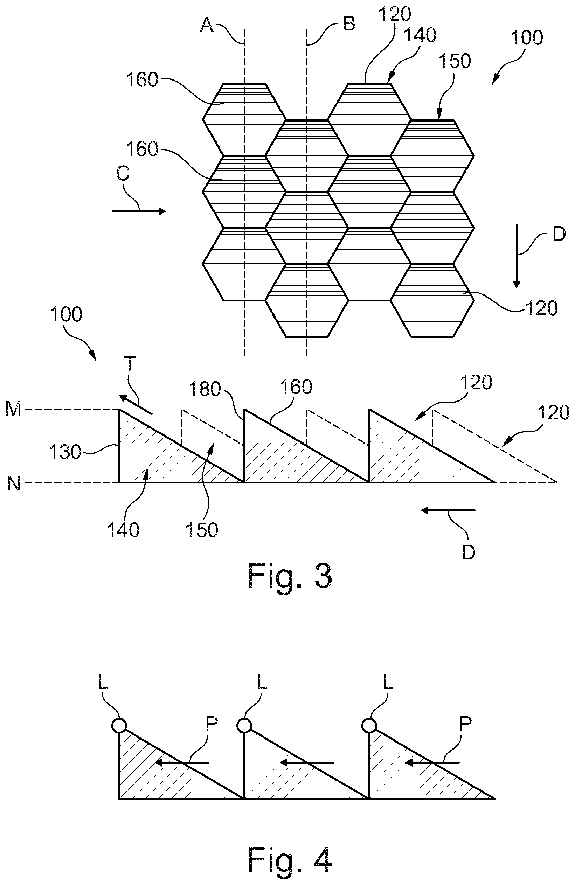

Fig. 3 stellt schematisch die im Schritt a) des zweiten Ausführungsbeispiels erzeugte Oberflächenstruktur 100 sowie eine Querschnittsansicht entlang der Ebene A durch eine der Spalten 140 der Oberflächenstruktur 100 dar. Der Querschnitt durch die Spalte 150 entlang der Ebene B ist analog zu Fig. 2b mit einer gestrichelten Linie veranschaulicht. Die Spalten 140 und 150 zeigen im vorliegenden Ausführungsbeispiel jeweils im Querschnitt ein Sägezahnmuster. Im vorliegenden Beispiel erstreckt sich die Fläche 160 mit der Steigung m in jedem Oberflächenbereich 120 bis zum Topniveau M, das mit dem Basisniveau N des in der gleichen Spalte folgenden Oberflächenbereichs 120 durch eine zum Basisniveau N senkrechte ebene Fläche 180 verbunden ist. Die Höhendifferenz zwischen in einer Spalte 140, 150 aufeinanderfolgenden Oberflächenbereichen 120 beträgt 10 µm, während zwischen Oberflächenbereichen 120 benachbarter Spalten 140 und 150 die Höhendifferenz 5 µm beträgt.

Auf die im Schritt a) des zweiten Ausführungsbeispiels erzeugte Oberflächenstruktur 100 wird eine Release-Schicht (nicht gezeigt) aus wasserlöslichem PVOH in einem Rolle-zu-Rolle-Prozess aufgedruckt. Die Schichtdicke der Release-Schicht ist im Vergleich zur Höhendifferenz der Oberflächenbereiche 120 so gewählt, dass sie diese abdeckt und die Erhebungen und Vertiefungen der Oberflächenstruktur 100 nachbildet. D.h. die Release-Schicht wird als mit der Oberflächenstruktur 100 konforme Schicht ausgebildet. Die Schichtdicke der Release-Schicht fällt typischerweise geringer als der Höhenversatz der Oberflächenstruktur 100 aus und kann bevorzugt mit einer Schichtdicke von 50nm bis 2µm aufgebracht werden. Die Release-Schicht kann beispielsweise mittels Tiefdruck, Flexodruck, Schlitzdüse oder Sprühdüse aufgetragen werden. Im vorliegenden Beispiel wird mittels Tiefdruck eine PVOH-Schicht von 500nm aufgedruckt.

Im Schritt b) des Verfahrens wird eine Pigmentmaterialschicht aus Aluminium (nicht gezeigt) auf die Release-Schicht mit einem PVD-Verfahren aufgebracht, was im Ablaufdiagramm der Fig. 5 dem Schritt S2 entspricht. Da die Steigung der Oberflächenbereiche 120 sowie die Anordnung der Oberflächenbereiche 120 in relativ zueinander versetzten Spalten 140 und 150 jeweils zu einem Höhenversatz führen, werden in der auf der Release-Schicht aufgebrachten Pigmentmaterialschicht Sollbruchstellen für die spätere Erzeugung der Pigmente bereitgestellt.

Im Schritt c) des Verfahrens wird die Pigmentmaterialschicht aus Aluminium von der Oberflächenstruktur 100 abgelöst, indem die Release-Schicht mit Wasser aufgelöst wird. Dabei wird durch Aufbrechen an den Sollbruchstellen der Pigmentmaterialschicht eine Vielzahl von Aluminium-Pigmenten mit im Wesentlichen gleicher hexagonaler Kontur mit einer engen Größenverteilung erzeugt, was im Ablaufdiagramm der Fig. 5 dem Schritt S3 entspricht.

Fig. 4 zeigt schematisch eine allgemeine Querschnittsansicht durch eine Oberflächenstruktur 10, 100 gemäß des ersten und des zweiten Ausführungsbeispiels. Da mit dem Verfahren auf dem Substrat Oberflächenbereiche 12, 120 gebildet werden, die zumindest teilweise eine schräg zu einem Basisniveau der Oberflächenstruktur verlaufende Steigung aufweisen, werden planparallele Oberflächen der Oberflächenstruktur vermieden. Evtl. durch das Prägen entstehende Luftblasen L sammeln sich, wie Fig. 4 zeigt, in der höchsten Region der Oberflächenbereiche 12, 120, und/oder in deren tiefsten Region. Daraus resultierende Oberflächendefekte der mit der Oberflächenstruktur erzeugten Pigmente entstehen an deren Rändern und beeinflussen deren optische oder funktionelle Eigenschaften nicht oder nur in geringem Ausmaß. Die Pfeile P veranschaulichen einen Materialfluss beim Prägen. Beim Prägen muss das zu verdrängende Material nur innerhalb eines Oberflächenbereiches transportiert werden und der Materialfluss beim Prägen verläuft nur in einer Richtung. Daher ist die zu verdrängende Menge an Prägematerial gering. So wird der Prägeprozess technisch signifikant erleichtert und die Qualität der Oberflächenstruktur und somit der im weiteren Verlauf des Verfahrens erzeugten Pigmente steigt.

### Bezugszeichenliste

- 10: Oberflächenstruktur
- 11: Substrat
- 12: Oberflächenbereich
- 13: Prägeschicht
- 14: Spalte
- 15: Spalte
- 16: Fläche
- 18: Fläche
- 19: Pigmentmaterialschicht
- 100: Oberflächenstruktur
- 120: Oberflächenbereich
- 130: Prägeschicht
- 140: Spalte
- 150: Spalte
- 160: Fläche
- 180: Fläche
- A: Ebene
- B: Ebene
- C: Pfeil der Blickrichtung
- D: Pfeil der Richtung der Spalten
- L: Luftblase
- M: Topniveau
- N: Basisniveau
- P: Pfeil eines Materialflusses beim Prägen
- T: Pfeil der Richtung der Steigung

## Patentansprüche

1. Verfahren zur Herstellung von Pigmenten definierter Größe und Form, mit den Schritten:
a) Erzeugen einer dreidimensionalen Oberflächenstruktur (10; 100) auf einem Substrat (11), wobei Oberflächenbereiche (12; 120) gebildet werden, die jeweils eine schräg zu einem Basisniveau (N) der Oberflächenstruktur verlaufende Steigung aufweisen, und in relativ zueinander versetzten Spalten (14, 15; 140, 150) angeordnet werden;
b) Aufbringen einer Pigmentmaterialschicht (19) auf der Oberflächenstruktur;
c) Ablösen der Pigmentmaterialschicht (19) von der Oberflächenstruktur und Erzeugen von Pigmenten.

2. Verfahren nach Anspruch 1,
wobei die Steigung mindestens eines Teils der Oberflächenbereiche (12; 120) ausgehend von dem Basisniveau der Oberflächenstruktur (10; 100) ausgebildet wird; und/oder
wobei die Steigung mindestens eines Teils der Oberflächenbereiche (12; 120) jeweils einen gleichen Steigungsvektor definiert; und/oder
wobei die Steigung mindestens eines Teils der Oberflächenbereiche bis zu einem Topniveau (M) der Oberflächenstruktur verlaufend ausgebildet wird und das jeweilige Topniveau der Oberflächenbereiche benachbart zu dem Basisniveau (M) eines angrenzenden Oberflächenbereiches (12; 120) derselben Spalte (14, 15; 140, 150) ausgebildet wird.

3. Verfahren nach Anspruch 2, wobei die Steigungsvektoren mindestens eines Teils der Oberflächenbereiche (12; 120) zueinander versetzt und/oder parallel zueinander angeordnet werden.

4. Verfahren nach einem der vorstehenden Ansprüche, wobei mindestens ein Teil der Spalten (14, 15; 140, 150) parallel zueinander angeordnet werden und/oder in einer Richtung angeordnet werden und/oder einen Spaltenvektor definieren.

5. Verfahren nach Anspruch 4, wobei mindestens ein Teil der Oberflächenbereiche derart ausgebildet wird, dass die Projektion des jeweiligen Steigungsvektors auf das Basisniveau parallel zum Spaltenvektor verläuft.

6. Verfahren nach einem der vorstehenden Ansprüche, wobei mindestens ein Teil der Oberflächenbereiche jeweils mit einer absoluten Höhendifferenz von 0,1 µm bis 150 µm, bevorzugt 0,5 µm bis 20 µm, mehr bevorzugt 1 µm bis 10 µm ausgebildet wird.

7. Verfahren nach einem der vorstehenden Ansprüche, wobei zumindest bei einem Teil der Oberflächenbereiche zwischen benachbarten Oberflächenbereiche der gleichen Spalte (14, 15; 140, 150) die gemittelte Höhendifferenz doppelt so groß ausgebildet wird wie die gemittelte Höhendifferenz zwischen Oberflächenbereichen benachbarter Spalten (14, 15; 140, 150).

8. Verfahren nach einem der vorstehenden Ansprüche, wobei mindestens ein Teil der Oberflächenbereiche mit gleicher Größe und/oder gleicher Form ausgebildet werden.

9. Verfahren nach einem der vorstehenden Ansprüche, wobei mindestens ein Teil der Oberflächenbereiche in Draufsicht auf die Oberflächenstruktur (10; 100) mit einer Kontur ausgewählt aus einer Polygonkontur, einer zueinander komplementären Kontur und einer Freiformkontur ausgebildet werden; und/oder
wobei mindestens ein Teil der Oberflächenbereiche mit einer oder mehreren Markierungen versehen werden.

10. Verfahren nach einem der vorstehenden Ansprüche, wobei mindestens ein Teil der Oberflächenbereiche jeder Spalte (14, 15; 140, 150) im Querschnitt der Oberflächenstruktur (10; 100) in Richtung des Spaltenvektors als ein Sägezahnmuster ausgebildet werden.

11. Verfahren nach einem der vorstehenden Ansprüche, wobei mindestens ein Teil der Spalten (14, 15; 140, 150) um die Hälfte einer Seitenlänge eines Oberflächenbereichs (12; 120) zueinander versetzt angeordnet werden.

12. Verfahren nach einem der vorstehenden Ansprüche,
wobei im Schritt a) das Erzeugen der dreidimensionalen Oberflächenstruktur (10; 100) zumindest teilweise durch ein Prägeverfahren erfolgt; und/oder
wobei im Schritt a) das Erzeugen der dreidimensionalen Oberflächenstruktur (10; 100) durch ein Verfahren erfolgt, ausgewählt aus:
a1) Einem Prägeverfahren mit den Schritten: Aufbringen einer löslichen Prägeschicht (13) als Release-Schicht auf das Substrat und Durchführen eines lithografischen, insbesondere photolithografischen, Prozesses, eines Heißprägens oder eines UV-Prägens; und/oder
a2) Einem Prägeverfahren mit den Schritten: Bereitstellen eines mittels Heißprägen verformbaren Substrats oder Aufbringen einer unlöslichen Prägeschicht (130) auf das Substrat, Durchführen eines Heißprägens oder eines UV-Prägens; und Aufbringen einer löslichen, insbesondere wasserlöslichen, Release-Schicht.

13. Verfahren nach einem der vorstehenden Ansprüche,
wobei im Schritt b) eine Pigmentmaterialschicht (19) umfassend ein oder mehrere anorganische Materialien und/oder ein oder mehrere organische Materialien auf der Oberflächenstruktur (10; 100) aufgebracht wird.

## Claims

1. Method for manufacturing pigments of defined size and shape, with the steps of:
a) producing a three-dimensional surface structure (10; 100) on a substrate (11), where surface regions (12; 120) are formed which each have a gradient extending obliquely to a base level (N) of the surface structure, and are arranged in columns (14, 15; 140, 150) which are offset relative to one another;
b) applying a pigment material layer (19) on the surface structure;
c) detaching the pigment material layer (19) from the surface structure and producing pigments.

2. Method according to Claim 1,
where the gradient of at least some of the surface regions (12; 120) is configured starting from the base level of the surface structure (10; 100); and/or
where the gradient of at least some of the surface regions (12; 120) in each case defines an identical gradient vector; and/or
where the gradient of at least some of the surface regions is configured so as to extend to a top level (M) of the surface structure and the respective top level of the surface regions is configured so as to be adjacent to the base level (M) of a bordering surface region (12; 120) of the same column (14, 15; 140, 150).

3. Method according to Claim 2, where the gradient vectors of at least some of the surface regions (12; 120) are arranged offset from one another and/or parallel to one another.

4. Method according to any of the preceding claims, where at least some of the columns (14, 15; 140, 150) are arranged parallel to one another and/or are arranged in one direction and/or define a column vector.

5. Method according to Claim 4, where at least some of the surface regions are configured in such a way that the projection of the respective gradient vector onto the base level extends parallel to the column vector.

6. Method according to any of the preceding claims, where at least some of the surface regions are configured each with an absolute height difference of 0.1 µm to 150 µm, preferably 0.5 µm to 20 µm, more preferably 1 µm to 10 µm.

7. Method according to any of the preceding claims, where for at least some of the surface regions, between adjacent surface regions of the same column (14, 15; 140, 150), the average height difference is twice as great as the average height difference between surface regions of adjacent columns (14, 15; 140, 150).

8. Method according to any of the preceding claims, where at least some of the surface regions are configured with identical size and/or identical shape.

9. Method according to any of the preceding claims, where at least some of the surface regions are configured, in plan view onto the surface structure (10; 100), with a contour selected from a polygonal contour, a mutually complementary contour, and a free-form contour; and/or
where at least some of the surface regions are provided with one or more marks.

10. Method according to any of the preceding claims, where at least some of the surface regions of each column (14, 15; 140, 150) are configured as a sawtooth pattern in the cross section of the surface structure (10; 100) in the direction of the column vector.

11. Method according to any of the preceding claims, where at least some of the columns (14, 15; 140, 150) are arranged offset from one another by half of a side length of a surface region (12; 120).

12. Method according to any of the preceding claims,
where in step a) the three-dimensional surface structure (10; 100) is produced at least partly by an embossing method; and/or
where in step a) the three-dimensional surface structure (10; 100) is produced by a method selected from:
a1) an embossing method with the steps of: applying a soluble embossing layer (13) as release layer to the substrate and performing a lithographic, more particularly photolithographic, operation, hot stamping or UV embossing; and/or
a2) an embossing method with the steps of: providing a substrate deformable by hot stamping, or applying an insoluble embossing layer (130) to the substrate, performing hot stamping or UV embossing; and applying a soluble, more particularly water-soluble, release layer.

13. Method according to any of the preceding claims, where in step b) a pigment material layer (19) comprising one or more inorganic materials and/or one or more organic materials is applied on the surface structure (10; 100).

## Revendications

1. Procédé de fabrication de pigments de taille et de forme définies, avec les étapes suivantes :
a) la production d'une structure de surface tridimensionnelle (10 ; 100) sur un substrat (11), des zones de surface (12 ; 120) étant formées, qui présentent chacune une pente s'étendant obliquement par rapport à un niveau de base (N) de la structure de surface, et sont agencées dans des colonnes (14, 15 ; 140, 150) décalées les unes par rapport aux autres ;
b) l'application d'une couche de matériau pigmentaire (19) sur la structure de surface ;
c) le détachement de la couche de matériau pigmentaire (19) de la structure de surface et la production de pigments.

2. Procédé selon la revendication 1,
dans lequel la pente d'au moins une partie des zones de surface (12 ; 120) est réalisée à partir du niveau de base de la structure de surface (10 ; 100) ; et/ou
dans lequel la pente d'au moins une partie des zones de surface (12 ; 120) définissant chacune un même vecteur de pente ; et/ou
dans lequel la pente d'au moins une partie des zones de surface est réalisée de manière à s'étendre jusqu'à un niveau supérieur (M) de la structure de surface et le niveau supérieur respectif des zones de surface est réalisé de manière voisine du niveau de base (M) d'une zone de surface adjacente (12 ; 120) de la même colonne (14, 15 ; 140, 150).

3. Procédé selon la revendication 2, dans lequel les vecteurs de pente d'au moins une partie des zones de surface (12 ; 120) sont agencés en décalage les uns par rapport aux autres et/ou parallèlement les uns aux autres.

4. Procédé selon l'une quelconque des revendications précédentes, dans lequel au moins une partie des colonnes (14, 15 ; 140, 150) sont agencées parallèlement les unes aux autres et/ou sont agencées dans une direction et/ou définissent un vecteur colonne.

5. Procédé selon la revendication 4, dans lequel au moins une partie des zones de surface est réalisée de telle sorte que la projection du vecteur de pente respectif sur le niveau de base est parallèle au vecteur de colonne.

6. Procédé selon l'une quelconque des revendications précédentes, dans lequel au moins une partie des zones de surface sont réalisées chacune avec une différence de hauteur absolue de 0,1 µm à 150 µm, de préférence de 0,5 µm à 20 µm, plus préférablement de 1 µm à 10 µm.

7. Procédé selon l'une quelconque des revendications précédentes, dans lequel, au moins pour une partie des zones de surface entre des zones de surface voisines de la même colonne (14, 15 ; 140, 150), la différence de hauteur moyenne est réalisée deux fois plus grande que la différence de hauteur moyenne entre des zones de surface de colonnes voisines (14, 15 ; 140, 150).

8. Procédé selon l'une quelconque des revendications précédentes, dans lequel au moins une partie des zones de surface sont réalisées avec la même taille et/ou la même forme.

9. Procédé selon l'une quelconque des revendications précédentes, dans lequel au moins une partie des zones de surface sont réalisées, en vue de dessus de la structure de surface (10 ; 100), avec un contour choisi parmi un contour polygonal, un contour mutuellement complémentaire et un contour de forme libre ; et/ou dans lequel au moins une partie des zones de surface sont pourvues d'un ou plusieurs marquages.

10. Procédé selon l'une quelconque des revendications précédentes, dans lequel au moins une partie des zones de surface de chaque colonne (14, 15 ; 140, 150) sont réalisées sous la forme d'un motif en dents de scie dans la section transversale de la structure de surface (10 ; 100) dans la direction du vecteur de colonne.

11. Procédé selon l'une quelconque des revendications précédentes, dans lequel au moins une partie des colonnes (14, 15 ; 140, 150) sont agencées en décalage les unes par rapport aux autres de la moitié d'une longueur de côté d'une zone de surface (12 ; 120).

12. Procédé selon l'une quelconque des revendications précédentes,
dans lequel, à l'étape a), la production de la structure de surface tridimensionnelle (10 ; 100) est effectuée au moins en partie par un procédé d'estampage ; et/ou
dans lequel, à l'étape a), la production de la structure de surface tridimensionnelle (10 ; 100) est effectuée par un procédé choisi parmi :
a1) un procédé d'estampage avec les étapes suivantes : l'application d'une couche d'estampage soluble (13) en tant que couche de libération sur le substrat et l'exécution d'un processus lithographique, en particulier photolithographique, d'un estampage à chaud ou d'un estampage UV ; et/ou
a2) un procédé d'estampage avec les étapes suivantes : la fourniture d'un substrat déformable par estampage à chaud ou l'application d'une couche d'estampage insoluble (130) sur le substrat, l'exécution d'un estampage à chaud ou d'un estampage UV ; et l'application d'une couche de libération soluble, en particulier soluble dans l'eau.

13. Procédé selon l'une quelconque des revendications précédentes,
dans lequel, à l'étape b), une couche de matériau pigmentaire (19) comprenant un ou plusieurs matériaux inorganiques et/ou un ou plusieurs matériaux organiques est appliquée sur la structure de surface (10 ; 100).
